# EUROPÄISCHE PATENTSCHRIFT

(11) **EP 1 402 567 B1**
(45) Veröffentlichungstag und Bekanntmachung des Hinweises auf die Patenterteilung: **26.04.2006**
(21) Anmeldenummer: 02758281.6
(22) Anmeldetag: 27.06.2002
(51) Int. Cl.: H01L 21/20, H01L 21/762

(54) **FILM ODER SCHICHT AUS HALBLEITENDEM MATERIAL UND VERFAHREN ZUR HERSTELLUNG DES FILMS ODER DER SCHICHT**
FILM OR LAYER MADE OF SEMI-CONDUCTIVE MATERIAL AND METHOD FOR PRODUCING SAID FILM OR LAYER
FILM OU COUCHE CONSTITUE(E) DE MATERIAU SEMICONDUCTEUR ET PROCEDE DE PRODUCTION DUDIT FILM OU DE LADITE COUCHE

(30) Priorität: 28.06.2001 DE 10131249
(43) Veröffentlichungstag der Anmeldung: 31.03.2004
(60) Teilanmeldung: 05021844.5
(73) Patentinhaber: Siltronic AG, 81737 München (DE)
(72) Erfinder: MURPHY, Brian, D-84347 Pfarrkirchen (DE); WAHLICH, Reinhold, D-84529 Tittmoning (DE); SCHMOLKE, Rüdiger, D-84489 Burghausen (DE); AMMON von, Wilfried, A-5122 Hockburg/Ach (AT); MORELAND, James, Portland, Oregon 97229 (US)
(74) Vertreter: Rimböck, Karl-Heinz
(86) Internationale Anmeldenummer: PCT/EP2002/007125
(87) Internationale Veröffentlichungsnummer: WO 2003/003430

(56) Entgegenhaltungen:
- EP-A- 0 553 852
- EP-A- 0 807 970
- EP-A- 0 895 282
- TSUNASHIMA Y ET AL: "A NEW SUBSTRATE ENGINEERING TECHNIQUE TO REALIZE SILICON ON NOTHING (SON) STRUCTUE UTILIZING TRANSFORMATION OF SUB-MICRON TRENCHES TO EMPTY SPACE IN SILICON (ESS) BY SURFACE MIGRATION" ELECTROCHEMICAL SOCIETY PROCEEDINGS, ELECTROCHEMICAL SOCIETY, PENNINGTON, NJ, US, Nr. 17, 2000, Seiten 532-545, XP008004134 ISSN: 0161-6374 in der Anmeldung erwähnt
- 'INTERNATIONAL TECHNOLOGY ROADMAP FOR SEMICONDUCTORS 2001 EDITION - FRONT END PROCESSES',
- PRIEUR E. ET AL: 'Threading dislocations in silicon layer produced by separation by implanted oxygen process' JOURNAL OF APPLIED PHYSICS Bd. 80, Nr. 4, 15 August 1996, Seiten 2113 - 2120, XP000633318
- PARK J.-G.: 'Nature of Surface defects in SOI wafers: SIMOX vs. Bonded SOI' PROCEEDINGS OF THE 3RD INTERNATIONAL SYMPOSIUM ON ADVANCED SCIENCE AND TECHNOLOGY OF SILICON MATERIAL, KONA, USA 2000, Seiten 660 - 666

## Beschreibung

Gegenstand der Erfindung ist eine SOI-Scheibe und ein Verfahren zur Herstellung eines Films bzw. einer Schicht aus halbleitendem Material.

So genannte SOI-Scheiben ("silicon on insulator") haben eine Schichtstruktur; in der Regel bestehend aus einem Träger, beispielsweise einer Siliciumscheibe, einer nahe unter der Oberfläche vergrabenen Oxidschicht sowie einer dünnen Siliciumschicht auf der Oxidschicht. Diese Schichtstruktur hat bei der Herstellung von elektronischen Bauelementen (z. B. Speicher und Mikroprozessoren) gegenüber den herkömmlich verwendeten Siliciumscheiben wesentliche Vorteile:

Es wird eine bessere Charakteristik der elektronischen Funktionen, verbunden mit höheren Schaltgeschwindigkeiten und einem geringeren Leistungsverbrauch des Bauelements erreicht. Zudem sind auf der Basis von SOI-Scheiben hergestellte Bauelemente besser für den Betrieb bei niedrigeren Spannungen geeignet als herkömmliche Bauelemente.

Aus diesen Gründen wird bei zukünftigen Bauelemente-Generationen der Einsatz von SOI-Scheiben wesentlich zunehmen. Die Qualitätsanforderungen an die SOI-Scheiben sind hoch, insbesondere an die Schichtdicken-Homogenitäten und die Defektdichten in der dünnen Siliciumschicht und in der Oxidschicht. Hier unterscheiden sich auch die verschiedenen Herstellungsverfahren und Produkte nach dem Stand der Technik:

Beispielsweise wird beim sog. SIMOX-Prozess durch die Implantation von Sauerstoff-Ionen durch die Oberfläche einer Siliciumscheibe in einer definierten Tiefe, die durch die Energie der Sauerstoff-Ionen bestimmt ist, eine Schicht mit hohem Sauerstoffgehalt erzeugt (Izumi et al., Electron Lett. 14 (18) (1978), p. 593). Diese Schicht wird in einer nachfolgenden thermischen Behandlung in eine Siliciumoxidschicht umgewandelt, die die darüber liegende dünne Siliciumschicht von dem darunter liegenden Rest der Siliciumscheibe trennt. Durch die Implantation der Sauerstoff-Ionen werden jedoch Kristallfehler ("Damage") in der dünnen Siliciumschicht erzeugt, die sich bei einer nachfolgenden Herstellung von elektronischen Bauelementen auf der SOI-Scheibe nachteilig auswirken.

Meist werden SOI-Scheiben allerdings durch den Transfer einer dünnen Siliciumschicht von einer ersten Scheibe, der Substratscheibe, auf eine zweite Scheibe, die Trägerscheibe, hergestellt. In der Regel bestehen beide Scheiben aus Silicium. Die dünne Siliciumschicht wird beispielsweise über eine isolierende Siliciumoxidschicht mit der Trägerscheibe verbunden. Es sind mehrere Verfahren bekannt, die für den Transfer dünner Siliciumschichten von einer ersten Scheibe auf eine zweite Scheibe und damit zur Herstellung einer SOI-Scheibe eingesetzt werden können:

Im so genannten SMARTCut-Prozess (US5374564; EP0807970A1; Weldon et al., J. Vac. Sci. Technolo., B 15(4) (1997), pp. 1065-1073) wird die Trennschicht mittels einer Wasserstoff-Implantation hergestellt, nach dem Verbinden ("Bonding") der zwei Scheiben erfolgt die Trennung ("Splitting") mittels thermischer Behandlung. Dabei entsteht eine relativ raue Oberfläche mit vielen Defekten, die anschließend durch Politur oder thermische Behandlung ("Anneal") geglättet werden muss. Es entstehen dabei auch nicht reparable Defekte (Löcher), sog. HFdefects, in der dünnen oberen Siliciumschicht mit einer Dichte von 0,1/cm² - 0,5/cm². Weiterhin entstehen durch die Implantation, die verwendete Trennschicht und das Trennverfahren Defekte in der oberen Siliciumschicht, die nach einem Secco-Ätzschritt sichtbar werden ("Secco etch defects") in der Größenordnung von 1·10²/cm² bis etwa 1·10⁴/cm² (J. G. Park, "Nature of Surface Defects in SOI wafers: SIMOX vs. Bonded SOI", JSPS, 3. International Symposium on Advanced Science and Technology of Silicon Material, 2000, Kona, USA).

Im so genannten ELTRAN-Prozess (US5854123; EP0553852A2; Yonehara et al., Electrochem. Soc. Proc. 99-3 (1999) pp. 111-116) wird die Trennschicht mittels eines anodischen Ätzverfahrens hergestellt, wobei eine poröse Oberflächenschicht entsteht. Diese bildet die Trennschicht. Anschließend wird auf dieser porösen Schicht eine epitaktische Schicht abgeschieden, die die spätere dünne Siliciumschicht bildet. Die Trennung erfolgt thermisch oder mechanisch, wobei sich hier wiederum Defekte in der Oberfläche sowie in der oberen Siliciumschicht bilden. Des weiteren kann die epitaktische Schicht nicht vollkommen störungsfrei auf der porösen Oberfläche aufwachsen. Die HF-Defektdichte (Löcher in der dünnen Siliciumschicht) beträgt 0,1/cm² - 0,3/cm², die Dichte der Secco etch defects liegt bei 5·10²/cm² - 1·10⁵/cm² je nach Schichtdicke der Siliciumschicht. Die Oberflächenrauhigkeit nach dem Splitting ist hoch mit 5 nm rms (scanning area 1 µm x 1 µm) und erfordert nachgeschaltete Glättungsverfahren. (Sakaguchi et al., Solid State Technology 43 (6) (2000) pp. 88-92).

Ein weiteres Verfahren ist der so genannte Nano-cleave-Prozess der Fa. SiGen, USA (Current et al., European Semiconductor, 22(2) (2000) pp. 25-27). In diesem Verfahren ist ein zusätzlicher Glättungsschritt nach der Trennung notwendig, um Rauhigkeitswerte unter 0,2 nm rms zu erzeugen (Thilderkvist et al., IEEE SOI Symposium, 2000, Wakefield, USA).

Es werden daher aufwendige Nachbehandlungsschritte durchgeführt, um die genannten Nachteile zu kompensieren. Beispielsweise wird gemäß der EP905767A1 die SOI-Scheibe durch ein Gasphasen-Ätzverfahren von der durch die Spaltung der Siliciumscheibe entlang der Schicht der Wasserstoff-Blasen erzeugten Defektschicht befreit. Dieses Verfahren erlaubt gleichzeitig eine eventuell gewünschte Dickenreduktion der Siliciumschicht. Die gleiche Wirkung wird durch eine thermische Oxidation der Silicium-Oberfläche und anschließende reduktive Entfernung des Siliciumoxids, wie in EP1045448A1 beschrieben, erzielt. Möglich ist auch eine thermische Behandlung der SOI-Scheibe in einer wasserstoffhaltigen Atmosphäre, um die Oberfläche der dünnen Siliciumschicht zu glätten und Kristalldefekte auszuheilen (EP1045448A1).

Der Erfindung liegt somit die Aufgabe zu Grunde, eine SOI-Scheibe mit einem Film oder einer Schicht aus halbleitendem Material, der bzw. die weitgehend frei von Kristalldefekten ist und eine glatte Oberfläche aufweist, sowie ein Verfahren zur Herstellung des Films bzw. der Schicht bereitzustellen.

Die Erfindung bezieht sich auf eine SOI-Scheibe, bestehend aus einer Trägerscheibe und einer dünnen Siliciumschicht, dadurch gekennzeichnet, dass die Siliciumschicht eine geringere Oberflächenrauhigkeit als 0,2 nm rms und eine Defektdichte bei den HF-Defekten kleiner als 0,1/cm² und bei den Secco-Etch-Defekten kleiner als 10/cm² aufweist.

Die Erfindung bezieht sich auch auf ein Verfahren zur Herstellung eines Films oder einer Schicht aus halbleitendem Material, umfassend folgende Schritte:
a) Erzeugung von Strukturen aus sich periodisch wiederholendenden Vertiefungen vorgegebener Geometrien auf der Oberfläche eines halbleitenden Materials,
b) thermische Behandlung des oberflächenstrukturierten Materials, bis sich eine Schicht mit sich periodisch wiederholenden Hohlräumen unter einer geschlossenen Schicht an der Oberfläche des Materials gebildet hat, bc) Verbinden der Oberfläche, unter der gemäß den Schritten a) und b) eine Schicht von Hohlräumen erzeugt wurde, mit der Oberfläche eines Trägermaterials und
c) Trennung der mit dem Trägermaterial verbundenen geschlossenen Schicht entlang der Schicht von Hohlräumen vom Rest des halbleitenden Materials.

Bei dem erfindungsgemäßen Verfahren werden stark kristallschädigende Prozesse wie Ionenimplantationen oder Ultrahochtemperaturschritte sowie grobe Schäden bei den Trennverfahren vermieden. Es ergeben sich dadurch neue, verbesserte Produkteigenschaften hinsichtlich der Defekte in der dünnen Schicht. Insbesondere treten in der dünnen Schicht keine strahlungsinduzierten Defekte auf, d. h. Defekte, die durch die bei einer Ionenimplantation angewendete Partikelstrahlung verursacht werden. Beim erfindungsgemäßen Verfahren sind keine Schichten nötig, die implantierte Ionen, z. B. Wasserstoff- oder Sauerstoff-Ionen enthalten.

Die Trennung an der Schicht der Hohlräume erfolgt spannungsfrei. Durch das schonende Trennverfahren werden in der Schicht aus halbleitendem Material keine oder nur geringe Kristallschäden erzeugt. Es ergeben sich dadurch neue, verbesserte Produkteigenschaften hinsichtlich der Defekte in der dünnen Schicht aus halbleitendem Material. Die glatteren Oberflächen zeigen gegenüber dem Stand der Technik direkt nach dem Trennen einen geringeren Rauhigkeitswert von 0,2 nm rms sowie deutlich verringerte Defektdichten von < 0,1/cm² für HF-Defekte und < 10/cm² für Secco-Etch-Defekte.

### Beschreibung der Figuren:

Fig. 1 zeigt den Ablauf des erfindungsgemäßen Verfahrens, bei dem ein Film bzw. eine Schicht aus halbleitendem Material auf ein Trägermaterial transferiert wird. Fig. 2 ist eine SEM-Aufnahme ("scanning electron microscope") eines Schnitts durch eine erfindungsgemäß den Schritten a) und b) unterworfene Siliciumscheibe.

Fig. 3 ist eine SEM-Aufnahme der in Fig. 2 dargestellten Siliciumscheibe, nachdem diese dem Trennschritt c) unterzogen wurde.

Im Folgenden wird anhand der Figuren das erfindungsgemäße Verfahren zur Herstellung eines Films oder einer Schicht eines halbleitenden Materials zusammen mit bevorzugten Ausführungsformen beschrieben. Das Herstellverfahren ist dargestellt als Kombination von Einzelschritten a) bis c), wobei jeder Einzelschritt fallweise Variationsmöglichkeiten beinhalten kann.

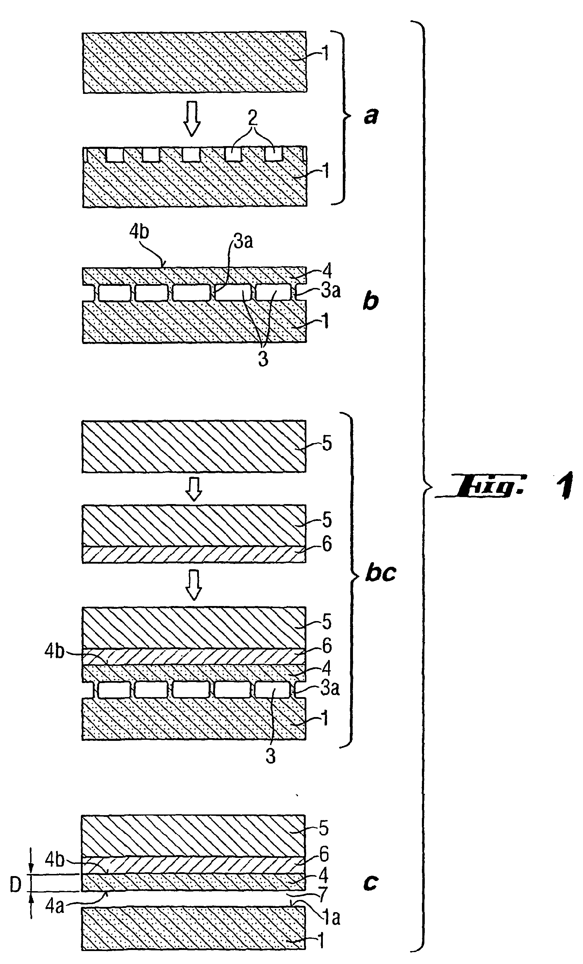

Im ersten Schritt a) werden auf der Oberfläche, ggf. auch auf einem Teil der Oberfläche des halbleitenden Ausgangsmaterials (Substrats) 1 Strukturen aus sich periodisch wiederholenden Vertiefungen 2 vorgegebener Geometrien erzeugt (in Fig. 1 schematisch dargestellt).

Das Verfahren kann auf beliebige halbleitende Materialien angewendet werden, bevorzugt jedoch auf Silicium-Germanium, Galliumarsenid, Siliciumcarbid und Indiumphosphid, besonders bevorzugt auf Silicium. Da Silicium bei der Herstellung von Halbleiterbauelementen von herausragender Bedeutung ist, werden die Vorteile und die bevorzugten Ausführungsformen des erfindungsgemäßen Verfahrens an Hand von Silicium erläutert, auch wenn die Anwendung nicht auf Silicium beschränkt ist.

Das Substrat kann aus verschiedenen Materialspezifikationen bestehen, wobei besonders die Ausführung des oberflächennahen Bereichs einen wesentlichen Einfluss auf die spätere Qualität der halbleitenden Schicht hat, da aus der Oberflächenschicht des Substrats der Film oder die Schicht aus halbleitendem Material entsteht.

Bevorzugt ist der Einsatz von scheibenförmigen Substraten mit ebenen Oberflächen. Besonders bevorzugt werden monokristalline Siliciumscheiben eingesetzt: CZ- oder FZ-Scheiben (d. h. Scheiben aus Einkristallen, die nach dem Czochralski-Verfahren bzw. dem Floating-Zone-Verfahren hergestellt wurden) mit beliebigen Dotierungen und Co-Dotierungen (beispielsweise stickstoffdotierte Scheiben), mit einer epitaktischen Schicht versehene Scheiben, thermisch behandelte Scheiben sowie Material ohne nennenswerte Leerstellen und interstitielle Konglomerate ("void free silicon" oder "perfect silicon") oder isotopenreines Silicium (²⁸Si).

Neu ist, dass neben der bekannten Oberflächenqualität "poliert" und "doppelseitenpoliert (DSP)" auch Scheiben ohne Spiegelpolitur (nicht haze-frei), feingeschliffene Scheiben ("fine ground") oder geätzte Scheiben eingesetzt.werden können.

Die Erzeugung der Vertiefungen 2 (Fig. 1) in der oberflächennahen Schicht im Schritt a) erfolgt mit den bekannten Verfahren der Photolithographie, der Masken- und Belichtungstechnik, dem Trench-Ätzen mittels Ionenstrahlätztechnik, dem Plasmaätzen, mit Hilfe eines Lasers oder ähnlicher Verfahren (Buch: "Silicon processing for the VLSI Era", S. Wolf, ISBN 0-961672-16-1). Die Dimensionen dieser Vertiefungen ("Trenches") 2 werden dabei hinsichtlich Breite, Durchmesser, Tiefe, Form und Abstand genau vorgegeben. Möglich sind Löcher, Gräben oder andere regelmäßige oder unregelmäßige geometrische Formen, wobei regelmäßige Formen bevorzugt und im Wesentlichen runde oder quadratische Löcher besonders bevorzugt sind.

Die Vertiefungen 2 werden in hoher Dichte auf einem Teilbereich der Oberfläche oder, bevorzugt, im Wesentlichen auf einer ganzen Fläche des Substrats 1 erzeugt. Beispielsweise wird bei scheibenförmigen Substraten bevorzugt eine der beiden Flächen im Wesentlichen ganzflächig mit Vertiefungen versehen. Die Vertiefungen werden derart erzeugt, dass Strukturen aus sich periodisch wiederholenden Vertiefungen vorgegebener Geometrien entstehen. Die geometrischen Abmessungen (d. h. im Wesentlichen Querschnitt, Tiefe und Abstand) der Vertiefungen werden so gewählt, dass die im weiteren Prozessverlauf entstehende Schicht aus halbleitendem Material die gewünschte Dicke D erhält. Dazu werden bevorzugt für den Durchmesser (bei runden Löchern) bzw. die Kantenlänge (bei quadratischen Löchern) D/5 bis 2·D (besonders bevorzugt D/3 bis D), für die Trenchtiefe D bis 4·D und den Trenchabstand D/2 bis 3·D gewählt.

Die geometrischen Abmessungen der Vertiefungen werden beispielsweise so gewählt, dass bei der nachfolgenden thermischen Behandlung in Schritt b) die aus den Vertiefungen entstehenden individuellen Hohlräume 3 zu größeren Hohlräumen 3 zusammenwachsen können. (Die in den Fig. 1 dargestellten Hohlräume 3 symbolisieren sowohl die individuellen Hohlräume als auch die größeren Hohlräume.) Bevorzugt werden in diesem Fall die Vertiefungen an wenigen genau positionierten Stellen in größeren Abständen erzeugt, sodass nach Schritt b) noch Stege 3a im Hohlraum 3 verbleiben.

Besonders bevorzugt ist es jedoch, die Löcher, die vorzugsweise alle die gleiche Geometrie aufweisen, in einem regelmäßigen, beispielsweise quadratischen oder hexagonalen Raster mit gleichbleibenden Loch-Loch-Abständen zu erzeugen und auf größere Abstände an bestimmten Stellen zu verzichten. Die geometrischen Abmessungen der Löcher sowie der Loch-LochAbstand werden in diesem Fall vorzugsweise so gewählt, dass bei der thermischen Behandlung gemäß Schritt b) die Oberfläche durch eine glatte Schicht geschlossen wird, die individuellen, aus den einzelnen Vertiefungen entstandenen Hohlräume aber noch nicht zu größeren Hohlräumen verschmelzen.

Im nachfolgenden Schritt b) wird das Substrat einer thermischen Behandlung unterzogen, die zur Folge hat, dass sich die Vertiefungen 2 auf Grund der Oberflächenbeweglichkeit der Atome oberflächlich schließen, sodass eine geschlossene Schicht 4 entsteht, und sich gleichzeitig Hohlräume 3 unterhalb der Schicht bilden. Die Schicht 4 oberhalb der Hohlräume bildet im weiteren Verfahren schließlich die Schicht oder den Film aus halbleitendem Material.

Die den Schritten a) und b) zu Grunde liegende Technik ist in der Publikation Tsunashima, Y., Sato, T. und Mizushima, I., Electrochem. Soc. Proc. 17 (2000), pp. 532-545, beschrieben.

Schritt b) wird vorzugsweise so gesteuert, dass sich dort, wo in Schritt a) Vertiefungen erzeugt wurden, ein durchgehender Hohlraum bildet, wobei der Zusammenhalt zwischen der Schicht 4 oberhalb der Hohlräume 3 und dem Rest des Substrats 1 durch absichtlich eingebaute Stege 3a in vorgegebenem Abstand gewährleistet wird. Die Stege entstehen an den Stellen, an denen in Schritt a) größere Abstände zwischen den Vertiefungen eingehalten wurden.

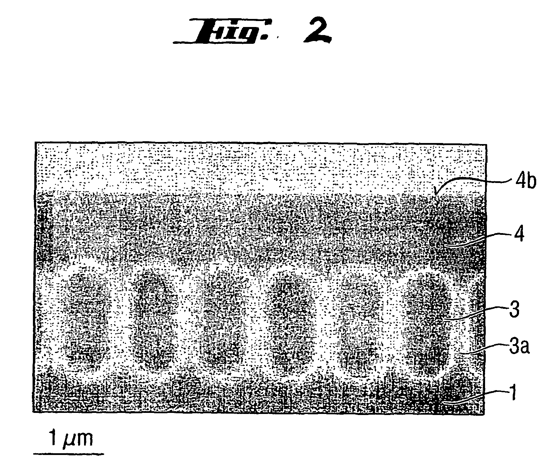

Falls die Vertiefungen in Schritt a) ohne größere Abstände an bestimmten Stellen erzeugt wurden, was besonders bevorzugt ist, wird die thermische Behandlung in Schritt b) derart gesteuert, dass die Oberfläche der Schicht 4 geschlossen ist, aber die aus den einzelnen Vertiefungen entstehenden individuellen Hohlräume 3 noch nicht zusammenwachsen. Fig. 2 ist eine SEM-Aufnahme eines Schnitts durch die entsprechend behandelte Oberfläche einer Siliciumscheibe. Sie zeigt eine geschlossene Schicht 4 über einer Schicht von individuellen, aus einzelnen Vertiefungen entstandenen Hohlräumen 3.

Die thermische Behandlung wird je nach Material zwischen 200 und 1500 °C durchgeführt, für 3 Sekunden bis 6 Stunden, wobei Temperatur und Zeitdauer zur Steuerung des Prozesses im oben geschilderten Sinn eingesetzt werden. Die thermische Behandlung kann in allen Atmosphären erfolgen, die die Bildung einer Oxidschicht ("native oxide") auf der Oberfläche des halbleitenden Materials verhindern, vorzugsweise in reduzierenden Gasen und Gasgemischen oder inerten Gasen und Gasgemischen. Bevorzugt ist eine Atmosphäre, die Wasserstoff oder Argon oder Mischungen aus Wasserstoff und Argon enthält. Die thermische Behandlung kann bei Atmosphärendruck oder reduziertem Druck erfolgen. Die Prozessbedingungen werden so gewählt, dass eine möglichst hohe Oberflächenbeweglichkeit der Atome des halbleitenden Materials erreicht werden kann.

Wird Silicium als Substrat verwendet, wird Schritt b) ausgeführt mit folgenden Einstellungen: Temperatur 700 - 1370 °C, bevorzugt 900 - 1250 °C, besonders bevorzugt 950 - 1150 °C, Druck 1.3 kPa - 13.3 kPa (1 - 100 Torr) bevorzugt 1.3 kPa - 6.7 kPa (1 - 50 Torr), besonders bevorzugt 6.7 kPa - 2.7 kPa (5 - 20 Torr), Dauer 3 Sekunden bis 6 Stunden, vorzugsweise 1 Minute bis 30 Minuten. Die thermische Behandlung wird in einer nicht oxidierenden Atmosphäre durchgeführt, die vorzugsweise Wasserstoff oder Argon oder ein Gemisch der beiden Gase enthält.

Bevorzugt werden die Prozessbedingungen in Schritt b) so gewählt, dass gleichzeitig das Ausheilen von COPs ("crystal originated pits", Leerstellenagglomerate) im Substrat und insbesondere in dem Film bzw. in der Schicht 4 oberhalb der Hohlräume 3 erfolgt. Im Fall von Silicium sind dafür Temperaturen über 1000 °C notwendig, wie in der EP 829559 A1 oder der US 5,935,320 beschrieben.

Zusätzlich kann in diesem Schritt die Oberflächenbeweglichkeit der Atome des halbleitenden Materials durch sanften Beschuss mit Ionen niedriger Energie ("low-energy ion bombardment") erhöht werden, was zum schnelleren Schließen der Vertiefungen führt, oder niedrigere Temperaturen oder kürzere Zeiten ermöglicht.

Zusätzlich zur thermischen Behandlung kann, integriert in diese oder daran anschließend, eine epitaktische Schicht auf der geschlossenen Oberfläche abgeschieden werden. Damit kann beispielsweise eine Verkürzung der Prozesszeit erreicht werden. Die Abscheidung einer epitaktischen Schicht ist auch sinnvoll, falls die Oberfläche der Substratscheibe nach der thermischen Behandlung allein, beispielsweise für ein ggf. vorgesehenes anschließendes Bonding, nicht ausreichend glatt sein sollte, was sich nachteilig auf das Bonding auswirken kann. Es ist bekannt, dass eine epitaktische Schicht einer Dicke von < 0,5 *µ*m kleine Oberflächeninhomogenitäten effizient ausgleicht, sofern die Abscheidetemperatur im Bereich der für die Hohlraumbildung geeigneten Temperaturen gewählt wird (T. Bearda, P. Mertens, M. M. Heyns, R. Schmolke, Jpn. J. Appl. Phys. 39 (2000) L841; R. Schmolke, M. Blietz, R. Schauer, D. Zemke, H. Oelkrug, W. v. Ammon, U. Lambert, D. Gräf, The Electrochem. Soc. PV2000-17 (2000) 3). Eine aus dieser Prozesskombination resultierende Schicht aus halbleitendem Material, bei der man gegebenenfalls aus einer Gesamtkostenbetrachtung eine Überschreitung der Zieldicke zulässt, kann mit einer geeigneten Nachbehandlung, wie sie im weiteren Kontext beschrieben wird, reproduzierbar und kontrolliert verringert werden.

Die zu erzeugende Schicht bzw. der Film 4 aus halbleitendem Material ist auf Grund ihrer bzw. seiner geringen Dicke mechanisch wenig stabil. Daher wird die Oberfläche des Substrats, unter der die Schicht von Hohlräumen erzeugt wurde, in einem weiteren Schritt bc) mit der Oberfläche eines Trägermaterials 5 verbunden ("Bonding"), wie in Fig. 1 schematisch dargestellt. Das Trägermaterial ist ein elektrisch isolierender Festkörper oder trägt zumindest eine elektrisch isolierende Schicht 6 an der Oberfläche. Als Trägermaterial dient bevorzugt ein Material aus der Gruppe Siliciumcarbid, Silicium-Germanium, Galliumarsenid, Quarz, Plastik, Glas und Keramik. Besonders bevorzugt ist Silicium als Trägermaterial. Im Fall des Siliciums ist eine elektrisch isolierende Schicht aus Siliciumoxid an der Oberfläche besonders bevorzugt. Bevorzugt ist auch, dass die Flächen von Substrat und Trägermaterial, die miteinander verbunden werden, die selben geometrischen Abmessungen haben. Ebenfalls bevorzugt ist eine scheibenförmige Gestalt des Trägermaterials.

Das Trägermaterial kann bereits einen eingebauten so genannten "internen Getter" enthalten, der im Bauelementprozess eingeschleppte Metallverunreinigungen bindet und von dem aktiven Bauelementebereich fernhält.

Die Verbindung des halbleitenden Materials 1 und des Trägermaterials 5 erfolgt mit den nach dem Stand der Technik bekannten Verfahren (Q.-Y. Tong and U. Gösele: "Semiconductor wafer processing", ISBN 0-471-57481-3).

Im letzten Schritt c) erfolgt die Trennung der Schicht bzw. des Films 4 vom Rest des Substrats 1, und zwar entlang der Schicht der Hohlräume 3. Aufgrund dieser Hohlräume geschieht die Trennung sehr materialschonend im Vergleich zu anderen Verfahren. Das Trennen erfolgt vorzugsweise thermisch, wobei die Hohlräume zusammenwachsen und die Trennung besonders schonend erfolgt.

Insbesondere im Fall der thermischen Trennung dürfen die aus den Trenches entstandenen, individuellen kleinen Hohlräume beim Bonding noch nicht vollständig zusammengewachsen sein, um die mechanische Stabilität der Substratscheibe für diesen Vorgang zu gewährleisten. Erst in einem thermischen Prozess nach oder während des Bonding-Prozesses dürfen die individuellen, kleinen Hohlräume zu bestenfalls einem großen verschmelzen. Dieser zweite thermische Schritt zum Trennen beinhaltet, falls es sich um ein aus Silicium bestehendes Substrat handelt, eine thermische Behandlung im Temperaturbereich von 800 bis 1370 °C, bevorzugt von 900 bis 1200 °C für eine Dauer von 3 s bis 4 h, bevorzugt von 1 bis 30 min. Dazu wird beispielsweise ein sog. Vertikalofen oder eine RTA-Anlage (Lampenofen für "rapid thermal anneal") eingesetzt. Die thermische Behandlung findet bei Atmosphärendruck oder reduziertem Druck in einer beliebigen Gasatmosphäre statt, vorzugsweise in einer reduzierenden oder inerten Gasatmosphäre, besonders bevorzugt in einer Atmosphäre, die Wasserstoff oder Argon oder eine Mischung aus Wasserstoff und Argon enthält. Um eine weitere Homogenisierung und Glättung der dünnen Schicht zu erreichen, kann es sinnvoll sein, die Dauer der thermischen Behandlung zu verlängern.

Es sind jedoch auch andere Verfahren bekannt, die verwendet werden können, um eine Trennung entlang der verschmolzenen Hohlräume zu ermöglichen. Unter den mechanischen Verfahren sind die Trennung durch Fluidstrahl (Sakaguchi et al., Solid State Technology 43 (6) (2000), pp. 88-92), die Anwendung von Scherkräften (Current et al., "Ultrashallow junctions or ultrathin SOI?", Solid State Technology, September 2000) und akustische Trennmethoden (unter Einsatz von Ultra- oder Megaschall) zu nennen. Auch eine chemische Spaltung durch Ätzabtrag der zwischen den Hohlräumen verbliebenen Stege durch geeignete Gase oder Flüssigkeiten (z. B. Flusssäure oder Mischungen aus Salpetersäure und Flusssäure) ist möglich. Möglich ist auch eine Kombination verschiedener Trennmethoden.

Bevorzugt ist auch eine Kombination des Schritts c) mit der Aufbringung einer epitaktischen Schicht auf der Oberfläche des halbleitenden Materials in einem Epitaxie-Reaktor, sodass die gewünschte Zieldicke der Schicht oder des Films eingestellt werden kann.

Besonders vorteilhaft erweist sich das erfindungsgemäße Verfahren bei der Herstellung von SOI-Strukturen. Es ermöglicht beispielsweise den Einsatz von Siliciumscheiben als Substrat, die aus tiegelgezogenen Einkristallen hergestellt wurden (CZ-Scheiben). Diese führen nach dem Stand der Technik dazu, dass die COPs, die die Siliciumscheiben enthalten, auch in der daraus hergestellten dünnen Siliciumschicht einer SOI-Scheibe zu finden sind, was in der Bauelementeherstellung zu Problemen führt. Aus diesem Grund werden nach dem Stand der Technik zweckmäßigerweise aus nach dem "Floating-Zone"-Verfahren tiegelfrei gezogenen Einkristallen hergestellte Siliciumscheiben (FZ-Scheiben) als Substratscheiben eingesetzt. Falls dies nicht geschieht, müssen die COPs in der dünnen Siliciumschicht nach der Herstellung der SOI-Scheibe durch eine thermische Behandlung, beispielsweise in einer Wasserstoffatmosphäre, ausgeheilt werden. Im Gegensatz dazu können beim erfindungsgemäßen Verfahren auch CZ-Scheiben problemlos als Substratscheiben verwendet werden, da beim thermischen Schließen der Oberfläche in Schritt b) gleichzeitig die COPs ausgeheilt werden können, was besonders bevorzugt ist.

Ein weiterer Vorteil des erfindungsgemäßen Verfahrens besteht darin, dass durch eine geeignete Anordnung und Form der in Schritt b) erzeugten Vertiefungen auch SOI-Scheiben mit ultradünnen Siliciumschichten mit einer Dicke von 50 nm oder weniger hergestellt werden können. Grundsätzlich kann, unter Beibehaltung des Tiefen/Breiten-Verhältnisses der einzelnen Vertiefung, eine umso dünnere und glattere Siliciumschicht hergestellt werden, je geringer Querschnitt und Abstand der Vertiefungen sind.

Der Zusammenhang zwischen den geometrischen Parametern der Vertiefungen und der Dicke der herzustellenden dünnen Siliciumschicht lässt sich durch Variation der geometrischen Parameter experimentell ermitteln. Die notwendige periodische Strukturierung für den Dickenbereich unter 50 nm kann beispielsweise mit Nanoimprintverfahren, Elektronenstrahl-Lithographie, Röntgenstrahl-Lithographie oder Extrem-UV-Lithographie realisiert werden. Zukünftig wird es möglich sein, die periodische Strukturierung aufgrund der Fortschritte in der Photolithographie (weitere, neuere Verfahren sind in Entwicklung) auch im Bereich 50 nm und darunter hochgenau durchzuführen, damit kann die Dikkenvariation solch dünner Schichten auf weniger als 5 % gedrückt werden.

Bereits heute können mit den oben genannten Verfahren geometrische Strukturen mit geometrischen Toleranzen ≤ 10 %, bevorzugt ≤ 5 % und besonders bevorzugt ≤ 1 % erreicht werden. Je enger die Toleranzen der geometrischen Strukturen sind, desto besser wird die resultierende Schichtdicken-Homogenität. Die Toleranz der Schichtdicke ist dabei generell geringer als die Toleranz der einzelnen geometrischen Strukturen. Damit sind Schichtdikken-Homogenitäten von 5 % und weniger erreichbar.

Durch die weitgehende Defektfreiheit und die hohe Oberflächenqualität der dünnen Siliciumschicht können aufwendige Nachbearbeitungsschritte reduziert oder vollständig eingespart werden, was zu einer erheblichen Kostensenkung bei der Herstellung der SOI-Scheiben führt.

Nach der Herstellung der SOI-Scheibe kann, wenn nötig, die Dikke der Siliciumschicht 4 eingestellt, d. h. erhöht oder erniedrigt werden. Zur Erhöhung der Schichtdicke kann beispielsweise eine epitaktische Siliciumschicht abgeschieden werden. Eine Verringerung der Schichtdicke ist mit den bekannten Verfahren der Politur, bevorzugt aber der Gasphasenätze oder der'Oberflächenoxidation mit anschließender reduktiver Entfernung der Siliciumoxidschicht möglich. Die Homogenität der Schichtdicke bleibt dabei erhalten, sodass Schichtdicken von 20 nm oder weniger mit einer Schichtdickenhomogenität von 5 % oder weniger erhalten werden können.

Ebenso kann nachfolgend, wenn nötig, die Rauhigkeit der Oberfläche reduziert werden. Hierzu kann entweder eine Politur oder eine erneute thermische Behandlung erfolgen. Diese erfolgt in einer reduzierenden oder inerten Atmosphäre, die vorzugsweise Wasserstoff oder Argon oder eine Mischung von Wasserstoff und Argon enthält, bei Atmosphärendruck oder reduziertem Druck, im Temperaturbereich zwischen 1000 und 1250 °C für 10 Sekunden bis 60 Minuten in einem Batch-Ofen oder Lampenofen ("rapid thermal annealer", RTA). Batch-Öfen sind Vertikalöfen oder Horizontalöfen mit Booten für 50 - 250 Siliciumscheiben pro Fahrt. RTA sind Lampenöfen zum Anneal jeweils einer Scheibe pro Fahrt im "cassette to cassette" Betrieb.

Besonders vorteilhafte Eigenschaften der SOI-Scheibe können durch folgende bevorzugte Ausführungsformen des erfindungsgemäßen Verfahrens erreicht werden:

Beim Einsatz einer FZ-Scheibe als Substratscheibe kann eine SOI-Scheibe mit einer dünnen Siliciumschicht erhalten werden, die nicht nur frei von voids, sondern auch BMD-frei ist. BMDs (bulk-micro-defects) sind Sauerstoffpräzipitate, voids sind Konglomerate von Kristallleerstellen.

Wird als Substratscheibe eine hoch stickstoffdotierte CZ-Scheibe verwendet, kann eine, verglichen mit herkömmlichen CZ-Scheiben, höhere Resistenz gegen Gleitungen und Versetzungsbildung erreicht werden. Hoch stickstoffdotierte CZ-Scheiben sind CZ-Scheiben mit einem Stickstoffgehalt von 1·10¹⁴ - 5·10¹⁵/cm³. Hoch stickstoffdotierte Scheiben zeigen gegenüber CZ-Scheiben ohne Stickstoff eine deutlich erhöhte Resistenz gegenüber thermisch induzierten Gleitungen und Versetzungen und zeigen höhere BMD-Dichten (Gräf et al., ECS PV 2000-17, pp. 319-330; Ammon et al., ECS PV 94-10 p. 136; Sueoka et al., ECS PV 2000-17, pp. 164-179).

Eine weitere Möglichkeit ist, ein anderes Trägermaterial als monokristallines Silicium zu verwenden, z. B. polykristallines Silicium, Glas oder Keramik.

Besonders vorteilhaft ist das erfindungsgemäße Verfahren auch für die Erzeugung von Strukturen, die aus mehreren Schichten oder Filmen bestehen, anzuwenden. Zu diesem Zweck wird das Verfahren mindestens zwei mal hintereinander ausgeführt, wobei nach dem ersten Durchgang das Trägermaterial mit der darauf befindlichen ersten Schicht aus halbleitendem Material erneut als Trägermaterial verwendet wird, sodass auf die erste Schicht eine oder mehrere weitere Schichten aufgebracht werden.

### Beispiel

Die glatte, ebene Oberfläche einer Siliciumscheibe 1 (Fig. 1) wurde in Schritt a) des erfindungsgemäßen Verfahrens mit periodisch wiederkehrenden Vertiefungen ("Trenches") 2 versehen. Die Trenches hatten einen quadratischen Querschnitt mit einer Kantenlänge von ca. 0,5 *µ*m, der Trench-Trench-Abstand betrug ca. 0,9 *µ*m. Die Trenches waren in einem quadratischen Raster regelmäßig angeordnet. Die Trenches wurden durch Ionenstrahlätzen nach Stand der Technik derart erzeugt, dass eine Trenchtiefe von 3 *µ*m entstand.

Anschließend wurde die strukturierte Oberfläche der Siliciumscheibe 1 in Schritt b) mittels einer 10 Minuten dauernden thermischen Behandlung in reiner Wasserstoffatmosphäre bei einem Druck von 13.3 kPa (10 Torr), einem Wasserstofffluss von 10 sccm und einer Temperatur von 1100 °C geschlossen. Dabei weiteten sich die aus den Trenches 2 entstandenen Hohlräume 3 parallel zur geschlossenen Scheibenoberfläche 4 um ca. 0,25 µm auf. Fig. 2 zeigt eine SEM-Aufnahme der entstandenen Hohlräume 3 und der darüber liegenden geschlossenen, perfekten und glatten Schicht 4. Diese geschlossene Oberfläche ist durch ihre Glattheit besonders gut für die Verbindung mit einer Trägerscheibe ("Bonding") nach Fig. 1 geeignet.

Die in Schritt b) vorbereitete Siliciumscheibe wurde in einem weiteren Schritt bc) mit ihrer Oberfläche 4b mit einer ebenfalls aus Silicium bestehenden, mit einer Siliciumoxidschicht 6 versehenen Trägerscheibe 5 mit einem kommerziell erhältlichen Bonder der Firma EVG, Schärding, Österreich, verbunden.

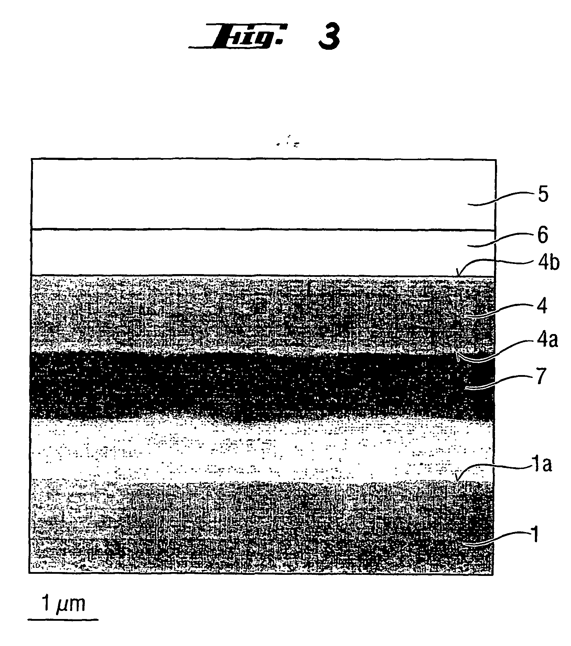

In Schritt c) wurden die über die Siliciumoxidschicht 6 verbundenen Siliciumscheiben einer weiteren thermischen Behandlung unterzogen. Dabei wurden die gleichen Bedingungen gewählt wie zum Schließen der Oberfläche in Schritt b). Durch diese thermische Behandlung verschmolzen die in Fig. 2 dargestellten Hohlräume 3, sodass ein durchgehender Hohlraum 7 (Fig. 3) entstand und die Siliciumschicht 4, die in Fig. 2 noch die Hohlräume 3 abdeckte, abgetrennt wurde. Fig. 3 zeigt die neu entststandene Oberfläche 1a der Substrat-Siliciumscheibe 1, darüber einen durchgehenden Hohlraum 7, der die erzeugte dünne Siliciumschicht 4 vollständig von der Siliciumscheibe 1 trennt. Die dünne Siliciumschicht 4 ist nun nur noch mit der Oxidschicht 6 der Träger-Siliciumscheibe 5 verbunden (5 und 6 schematisch dargestellt). Die Dicke der Schicht 4 beträgt ca. 1 *µ*m, sie liegt lose auf dem verbleibenden Teil des Substrats 1. Im Vergleich zur Oberfläche 1a des verbleibenden Teils des Substrats ist die Oberfläche 4a der abgetrennten dünnen Siliciumschicht 1 bereits sehr glatt. Der Focus der Fig. 3 liegt auf der Oberfläche 4a, die für die Herstellung von elektronischen Bauelementen vorgesehen ist.

## Patentansprüche

1. Verfahren zur Herstellung eines Films oder einer Schicht aus halbleitendem Material, umfassend folgende Schritte:
a) Erzeugung von Strukturen aus sich periodisch wiederholenden Vertiefungen vorgegebener Geometrien auf der Oberfläche eines halbleitenden Materials,
b) thermische Behandlung des oberflächenstrukturierten Materials, bis sich eine Schicht mit sich periodisch wiederholenden Hohlräumen unter einer geschlossenen Schicht an der Oberfläche des Materials gebildet hat,
bc) Verbinden der Oberfläche, unter der gemäß den Schritten a) und b) eine Schicht von Hohlräumen erzeugt wurde, mit der Oberfläche eines Trägermaterials und
c) Trennung der mit dem Trägermaterial verbundenen geschlossenen Schicht entlang der Schicht von Hohlräumen vom Rest des halbleitenden Materials.

2. Verfahren nach Anspruch 1, **dadurch gekennzeichnet, dass** das halbleitende Material aus einer Gruppe ausgewählt wird, die Silicium, Silicium-Germanium, Galliumarsenid, Siliciumcarbid und Indiumphosphid umfasst.

3. Verfahren nach Anspruch 2, **dadurch gekennzeichnet, dass** das halbleitende Material monokristallin ist.

4. Verfahren nach einem oder mehreren der Ansprüche 1 bis 3, **dadurch gekennzeichnet, dass** die Vertiefungen Löcher oder Gräben sind.

5. Verfahren nach Anspruch 4, **dadurch gekennzeichnet, dass** die Vertiefungen Löcher mit im Wesentlichen rundem oder quadratischem Querschnitt sind, wobei alle Löcher die gleiche Geometrie aufweisen und in einem regelmäßigen Raster mit gleich bleibenden Loch-Loch-Abständen angeordnet sind.

6. Verfahren nach einem der Ansprüche 1 bis 5, **dadurch gekennzeichnet, dass** die geometrischen Abmessungen der Vertiefungen in Abhängigkeit von der gewünschten Dicke des zu erzeugenden Films bzw. der zu erzeugenden Schicht gewählt werden.

7. Verfahren nach einem der Ansprüche 1 bis 6, **dadurch gekennzeichnet, dass** die geometrischen Abmessungen der Vertiefungen und die Abstände der Vertiefungen untereinander so gewählt werden, dass sich bei der thermischen Behandlung in Schritt b) eine geschlossene Oberfläche über einer Schicht von individuellen, aus den Vertiefungen entstehenden Hohlräumen bilden kann, ohne dass die individuellen Hohlräume zu größeren Hohlräumen verschmelzen.

8. Verfahren nach einem der Ansprüche 1 bis 7, **dadurch gekennzeichnet, dass** die thermische Behandlung in Schritt b) in einer Atmosphäre ausgeführt wird, die die Bildung einer Oxidschicht auf dem halbleitenden Material verhindert.

9. Verfahren nach Anspruch 8, **dadurch gekennzeichnet, dass** die Atmosphäre Wasserstoff und/oder Argon enthält.

10. Verfahren nach einem der Ansprüche 1 bis 9, **dadurch gekennzeichnet, dass** die Bedingungen der thermischen Behandlung in Schritt b) so gewählt werden, dass gleichzeitig ein Ausheilen der im halbleitenden Material enthaltenen COPs erfolgt.

11. Verfahren nach einem der Ansprüche 1 bis 10, **dadurch gekennzeichnet, dass** die thermische Behandlung in Schritt b) mit einem Beschuss der Oberfläche mit Ionen niedriger Energie kombiniert wird.

12. Verfahren nach einem der Ansprüche 1 bis 11, **dadurch gekennzeichnet, dass** das Verfahren mindestens zwei mal hintereinander ausgeführt wird, derart, dass das Trägermaterial mit der darauf befindlichen Schicht aus halbleitendem Material erneut als Trägermaterial verwendet wird, sodass auf die erste Schicht eine oder mehrere weitere Schichten aufgebracht werden.

13. Verfahren nach einem der Ansprüche 1 bis 12, **dadurch gekennzeichnet, dass** das Trägermaterial aus einer Gruppe ausgewählt wird, die Silicium, Silicium-Germanium, Siliciumcarbid, Galliumarsenid, Quarz, Plastik, Glas und Keramik umfasst.

14. Verfahren nach Anspruch 13, **dadurch gekennzeichnet, dass** das Trägermaterial an der Oberfläche eine elektrisch isolierende Schicht trägt.

15. Verfahren nach einem der Ansprüche 1 bis 14, **dadurch gekennzeichnet, dass** die Trennung in Schritt c) durch eine mechanische, chemische oder thermische Behandlung oder eine, Kombination daraus erfolgt.

16. Verfahren nach Anspruch 15, **dadurch gekennzeichnet, dass** die thermische Behandlung in Schritt c) zu einer Verschmelzung der in Schritt b) erzeugten Hohlräume und damit zur Trennung führt.

17. Verfahren nach Anspruch 16, **dadurch gekennzeichnet, dass** die thermische Behandlung in Schritt c) bei einer Temperatur zwischen 800 und 1370 °C bei Atmosphärendruck oder reduziertem Druck für eine Dauer von 3 Sekunden bis 4 Stunden erfolgt.

18. Verfahren nach Anspruch 15, **dadurch gekennzeichnet, dass** die mechanische Behandlung ausgewählt wird aus einer Gruppe bestehend aus Anwendung von Scherkräften, Behandlung mit einem Fluidstrahl und akustische Behandlung mit Ultra- oder Megaschall.

19. Verfahren nach einem der Ansprüche 1 bis 18, **dadurch gekennzeichnet, dass** das halbleitende Material in Form einer Scheibe vorliegt.

20. Verfahren nach einem oder mehreren der Ansprüche 1 bis 19, **dadurch gekennzeichnet, dass** das Trägermaterial in Form einer Scheibe vorliegt.

21. Verfahren nach einem oder mehreren der Ansprüche 1 bis 20, **dadurch gekennzeichnet, dass** die Flächen von halbleitendem Material und Trägermaterial, die miteinander verbunden werden, die selben geometrischen Abmessungen haben.

22. SOI-Scheibe, bestehend aus einer Trägerscheibe und einer dünnen Siliciumschicht, **dadurch gekennzeichnet, dass** die Siliciumschicht eine geringere Oberflächenrauhigkeit als 0,2 nm rms und eine Defektdichte bei den HF-Defekten kleiner als 0,1/cm² und bei den Secco-Etch-Defekten kleiner als 10/cm² aufweist.

23. SOI-Scheibe nach Anspruch 22, **dadurch gekennzeichnet, dass** die dünne Siliciumschicht eine Dicke von 50 nm oder weniger und eine Dickenvariation von 5 % oder weniger aufweist.

24. SOI-Scheibe nach Anspruch 23, **dadurch gekennzeichnet, dass** die dünne Siliciumschicht frei von strahlungsinduzierten Defekten ist.

## Claims

1. Process for producing a film or a layer of semiconducting material, comprising the following steps:
a) the production of structures comprising periodically recurring recesses of predetermined geometries on the surface of a semiconducting material,
b) heat treatment of the surface-structured material until a layer comprising periodically recurring cavities has formed beneath a closed layer at the surface of the material,
bc) joining the surface beneath which a layer of cavities has been produced in accordance with steps a) and b) to the surface of a carrier material and
c) separation of the closed layer joined to the carrier material from the remainder of the semiconducting material along the layer of cavities.

2. Process according to Claim 1, **characterized in that** the semiconducting material is selected from a group consisting of silicon, silicon-germanium, gallium arsenide, silicon carbide and indium phosphide.

3. Process according to Claim 2, **characterized in that** the semiconducting material is monocrystalline.

4. Process according to one or more of Claims 1 to 3, **characterized in that** the recesses are holes or trenches.

5. Process according to Claim 4, **characterized in that** the recesses are holes which are substantially round or square in cross section, all the holes having the same geometry and being arranged in a regular pattern with constant hole-to-hole distances.

6. Process according to one of Claims 1 to 5, **characterized in that** the geometric dimensions of the recesses are selected as a function of the desired thickness of the film or layer which is to be produced.

7. Process according to one of Claims 1 to 6, **characterized in that** the geometric dimensions of the recesses and the distances between the recesses are selected in such a way that, during the heat treatment in step b), a closed surface can form above a layer of individual cavities which form from the recesses, without the individual cavities fusing together to form larger cavities.

8. Process according to one of Claims 1 to 7, **characterized in that** the heat treatment in step b) is carried out in an atmosphere which prevents the formation of a layer of oxide on the semiconducting material.

9. Process according to Claim 8, **characterized in that** the atmosphere contains hydrogen and/or argon.

10. Process according to one of Claims 1 to 9, **characterized in that** the conditions of the heat treatment in step b) are selected in such a way that the COPs which are present in the semiconducting material are simultaneously annealed.

11. Process according to one of Claims 1 to 10, **characterized in that** the heat treatment in step b) is combined with a low-energy ion bombardment of the surface.

12. Process according to one of Claims 1 to 11, **characterized in that** the process is carried out at least twice in succession, in such a manner that the carrier material with the layer of semiconducting material located thereon is used once again as a carrier material, so that one or more further layers are applied to the first layer.

13. Process according to in one of Claims 1 to 12, **characterized in that** the carrier material is selected from a group consisting of silicon, silicon-germanium, silicon carbide, gallium arsenide, quartz, plastic, glass and ceramic.

14. Process according to Claim 13, **characterized in that** the carrier material bears an electrically insulating layer at the surface.

15. Process according to one of Claims 1 to 14, **characterized in that** the separation in step c) is carried out by means of a mechanical, chemical or heat treatment or a combination thereof.

16. Process according to Claim 15, **characterized in that** the heat treatment in step c) leads to fusion of the cavities which have been produced in step b) and therefore to separation.

17. Process according to Claim 16, **characterized in that** the heat treatment in step c) takes place at a temperature of between 800 and 1370°C at atmospheric pressure or reduced pressure for a period of from 3 seconds to 4 hours.

18. Process according to Claim 15, **characterized in that** the mechanical treatment is selected from a group consisting of the application of shear forces, treatment with a jet of fluid and acoustic treatment with ultrasound or megasound.

19. Process according to one of Claims 1 to 18, **characterized in that** the semiconducting material is in the form of a wafer.

20. Process according to one or more of Claims 1 to 19, **characterized in that** the carrier material is in the form of a wafer.

21. Process according to one or more of Claims 1 to 20, **characterized in that** the surfaces of semiconducting material and carrier material which are joined to one another have the same geometric dimensions.

22. SOI wafer, comprising a carrier wafer and a thin layer of silicon, **characterized in that** the silicon layer has a surface roughness of less than 0.2 nm rms and a defect density of less than 0.1/cm² in the case of the HF defects and less than 10/cm² in the case of the Secco etch defects.

23. SOI wafer according to Claim 22, **characterized in that** the thin layer of silicon has a thickness of 50 nm or less and a thickness variation of 5% or less.

24. SOI wafer according to Claim 23, **characterized in that** the thin layer of silicon is free of radiation-induced defects.

## Revendications

1. Procédé de fabrication d'un film ou d'une couche en matériau semi-conducteur, qui comprend les étapes suivantes:
a) créer des structures de géométries prédéterminées en creux répétés périodiquement à la surface d'un matériau semi-conducteur,
b) traiter thermiquement le matériau à surface structurée jusqu'à ce qu'une couche qui présente des creux qui se répètent périodiquement en dessous d'une couche fermée se soit formée à la surface du matériau,
bc) relier à la surface d'un matériau de support la surface en dessous de laquelle une couche d'espaces creux a été créée par les étapes a) et b) et
c) le long de la couche d'espaces creux, séparer du reste du matériau semi-conducteur la couche fermée reliée à la couche de support.

2. Procédé selon la revendication 1, **caractérisé en ce que** le matériau semi-conducteur est sélectionné dans le groupe qui comporte le silicium, le silicium-germanium, l'arséniure de gallium, le carbure de silicium et le phosphure d'indium.

3. Procédé selon la revendication 2, **caractérisé en ce que** le matériau semi-conducteur est monocristallin.

4. Procédé selon l'une ou plusieurs des revendications 1 à 3, **caractérisé en ce que** les creux sont des trous ou des sillons.

5. Procédé selon la revendication 4, **caractérisé en ce que** les creux sont des trous de section transversale essentiellement ronde ou carrée, tous les trous présentant la même géométrie et étant disposés suivant un motif régulier avec des écarts constants entre les trous.

6. Procédé selon l'une quelconque des revendications 1 à 5, **caractérisé en ce que** les dimensions géométriques des creux sont sélectionnées en fonction de l'épaisseur souhaitée du film ou selon le cas de la couche à créer.

7. Procédé selon l'une quelconque des revendications 1 à 6, **caractérisé en ce que** les dimensions géométriques des creux et les distances mutuelles entre les creux sont sélectionnées de telle sorte que lors du traitement thermique de l'étape b), on puisse former une surface fermée au-dessus d'une couche d'espaces creux individuels dérivés des creux sans que les espaces creux individuels fusionnent en espaces creux plus grands.

8. Procédé selon l'une quelconque des revendications 1 à 7, **caractérisé en ce que** le traitement thermique de l'étape b) est réalisé dans une atmosphère qui inhibe la formation d'une couche d'oxyde sur le matériau semi-conducteur.

9. Procédé selon la revendication 8, **caractérisé en ce que** l'atmosphère contient de l'hydrogène et/ou de l'argon.

10. Procédé selon l'une quelconque des revendications 1 à 9, **caractérisé en ce que** les conditions du traitement thermique à l'étape b) sont sélectionnées de telle sorte que l'on obtienne en même temps une régénération des COP contenus dans le matériau semi-conducteur.

11. Procédé selon l'une quelconque des revendications 1 à 10, **caractérisé en ce que** le traitement thermique de l'étape b) est combiné avec un bombardement de la surface par des ions à basse énergie.

12. Procédé selon l'une quelconque des revendications 1 à 11, **caractérisé en ce que** le procédé est réalisé au moins deux fois successivement de telle sorte que le matériau de support sur lequel est située la couche en matériau semi-conducteur soit réutilisé comme matériau de support pour appliquer une ou plusieurs autres couches sur la première couche.

13. Procédé selon l'une quelconque des revendications 1 à 12, **caractérisé en ce que** le matériau de support est sélectionné dans l'ensemble qui comporte le silicium, le silicium-germanium, le carbure de silicium, l'arséniure de gallium, le quartz, les matières plastiques, le verre et les céramiques.

14. Procédé selon la revendication 13, **caractérisé en ce que** le matériau de support porte une couche électriquement isolante à sa surface.

15. Procédé selon l'une quelconque des revendications 1 à 14, **caractérisé en ce que** la séparation à l'étape c) est réalisée par un traitement mécanique, un traitement chimique, un traitement thermique ou une combinaison de ces traitements.

16. Procédé selon la revendication 15, **caractérisé en ce que** le traitement thermique de l'étape c) entraîne une fusion des espaces creux créés à l'étape b), et donc une séparation.

17. Procédé selon la revendication 16, **caractérisé en ce que** le traitement thermique de l'étape c) est réalisé à une température comprise entre 800 et 1 370°C sous une pression atmosphérique ou sous pression réduite pendant une durée de 3 secondes à 4 heures.

18. Procédé selon la revendication 15, **caractérisé en ce que** le traitement mécanique est sélectionné dans l'ensemble constitué de l'utilisation de forces de cisaillement, d'un traitement à l'aide d'un jet de fluide et d'un traitement acoustique par des ultrasons ou mégasons.

19. Procédé selon l'une quelconque des revendications 1 à 18, **caractérisé en ce que** le matériau semi-conducteur présente la forme d'un disque.

20. Procédé selon l'une ou plusieurs des revendications 1 à 19, **caractérisé en ce que** le matériau de support présente la forme d'un disque.

21. Procédé selon l'une ou plusieurs des revendications 1 à 20, **caractérisé en ce que** les surfaces du matériau semi-conducteur et du matériau de support qui sont reliées l'une à l'autre ont les mêmes dimensions géométriques.

22. Disque SOI constitué d'un disque de support et d'une mince couche de silicium, **caractérisé en ce que** la couche de silicium a une rugosité de surface inférieure à 0,2 nm rms et une densité de défauts HF inférieure à 0,1/cm² et inférieure à 10/cm² pour les défauts de gravure Secco.

23. Disque SOI selon la revendication 22, **caractérisé en ce que** la mince couche de silicium a une épaisseur de 50 nm ou moins et une variation d'épaisseur de 5% ou moins.

24. Disque SOI selon la revendication 23, **caractérisé en ce que** la mince couche de silicium est exempte de défauts induits par irradiation.
